(19) Europäisches Patentamt / European Patent Office / Office européen des brevets

(11) **EP 4 047 679 B1**

(12) **EUROPEAN PATENT SPECIFICATION**

(45) Date of publication and mention
of the grant of the patent:
**15.04.2026 Bulletin 2026/16**

(21) Application number: **20901464.6**

(22) Date of filing: **20.10.2020**

(51) International Patent Classification (IPC):
$H01M\ 4/1315^{(2010.01)}$   $H01M\ 4/525^{(2010.01)}$
$H01M\ 4/505^{(2010.01)}$   $H01M\ 10/052^{(2010.01)}$
$H01M\ 4/02^{(2006.01)}$   $C01G\ 53/00^{(2025.01)}$

(52) Cooperative Patent Classification (CPC):
**C01G 53/50; C01G 53/82; H01M 4/131;
H01M 4/505; H01M 4/525; H01M 10/0525;**
C01P 2004/32; C01P 2004/45; C01P 2004/51;
C01P 2004/61; C01P 2006/40; Y02E 60/10

(86) International application number:
**PCT/KR2020/014316**

(87) International publication number:
**WO 2021/125535 (24.06.2021 Gazette 2021/25)**

(54) **CATHODE OPTIMIZED FOR IMPROVING HIGH-TEMPERATURE LIFESPAN CHARACTERISTICS, AND SECONDARY BATTERY COMPRISING SAME**

OPTIMIERTE KATHODE ZUR VERBESSERUNG DER HOCHTEMPERATUR-LEBENSDAUER UND DIESE ENTHALTENDE SEKUNDÄRBATTERIE

CATHODE OPTIMISÉE POUR AMÉLIORER SES CARACTÉRISTIQUES DE DURÉE DE VIE À HAUTE TEMPÉRATURE, ET BATTERIE RECHARGEABLE LA COMPRENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.12.2019 KR 20190170943
12.10.2020 KR 20200131094**

(43) Date of publication of application:
**24.08.2022 Bulletin 2022/34**

(60) Divisional application:
**26159492.3 / 4 722 165**

(73) Proprietor: **LG Energy Solution, Ltd.
Seoul 07335 (KR)**

(72) Inventors:
• **LEE, Sang Wook**
  **Daejeon 34122 (KR)**
• **HAN, Gi Beom**
  **Daejeon 34122 (KR)**
• **KIM, Hakyoon**
  **Daejeon 34122 (KR)**
• **BAEK, Sora**
  **Daejeon 34122 (KR)**
• **HAN, Jungmin**
  **Daejeon 34122 (KR)**
• **JUNG, Wang Mo**
  **Daejeon 34122 (KR)**

(74) Representative: **Hoffmann Eitle
Patent- und Rechtsanwälte PartmbB
Arabellastraße 30
81925 München (DE)**

(56) References cited:
WO-A1-2019/088806    JP-A- 2012 216 549
JP-B1- 6 388 978    JP-B2- 5 804 419
KR-A- 20140 098 350    KR-A- 20190 026 571
KR-A- 20190 041 715    KR-A- 20190 051 863
KR-A- 20190 127 725    US-B2- 9 564 628

**Description**

**[TECHNICAL FIELD]**

The present disclosure relates to a positive electrode optimized for improving high-temperature life characteristics and a secondary battery comprising the same.

**[BACKGROUND ART]**

Due to the rapid increase in the use of fossil fuels, the demand for the use of alternative energy or clean energy is increasing, and as a part thereof, the fields that are being studied most actively are the fields of power generation and power storage using electrochemistry.

Currently, a secondary battery is a representative example of an electrochemical device that utilizes such electrochemical energy, and the range of use thereof tends to be gradually expanding.

Recently, with the increase of the technological development and demand for mobile devices such as portable computers, portable phones, and cameras, demand for secondary batteries as an energy source rapidly increases. Among such secondary batteries, many studies have been conducted on a lithium secondary battery that that exhibit high energy density and operating potential, have a long cycle life, and a low self-discharge rate, and has been commercialized and widely used.

In addition, as interest in environmental issues grows, studies are frequently conducted on an electric vehicle, a hybrid electric vehicle, etc. which can replace a vehicle using fossil fuels such as a gasoline vehicle and a diesel vehicle, which are one of the main causes of air pollution. Although a nickel metal hydride secondary battery is mainly used as a power source for the electric vehicle and the hybrid electric vehicle, research on the use of a lithium secondary battery having high energy density and discharge voltage is actively being conducted, a part of which are in the commercialization stage.

Currently, as the positive electrode material for lithium secondary batteries, lithium-containing cobalt oxide ($LiCoO_2$) is mainly used. Besides that, the use of lithium-containing manganese oxide, such as $LiMnO_2$ having a layered crystal structure and $LiMn_2O_4$ having a spinel crystal structure, and lithium-containing nickel oxide ($LiNiO_2$) is also being considered.

Among the above-mentioned positive electrode active materials, $LiCoO_2$ is most frequently used due to excellent life characteristics and excellent charge and discharge efficiency. However, since $LiCoO_2$ has poor structural stability and poor price competitiveness due to limits in resource of cobalt used as a raw material, it has limitations in mass use as a power source in fields such as electric vehicles.

$LiNiO_2$-based positive electrode active materials have relatively low prices and high discharge capacity battery characteristics, but have problems in that a rapid phase transition in a crystal structure may occur according to the volume change accompanying charge/discharge cycles, and the stability may be sharply lowered when exposed to air and moisture.

In addition, lithium manganese oxides such as $LiMnO_2$ or $LiMn_2O_4$ have advantages in that they have excellent thermal stability and a relatively low price, but have problems, such as a small capacity, poor cycle characteristics, and poor high temperature characteristics.

Thus, recently, a ternary or quaternary lithium transition metal oxide containing three or more transition metals has been developed by substituting a part of $LiNiO_2$ with Co, Mn, Al, or the like.

The ternary or quaternary lithium transition metal oxide is generally used by forming a secondary particle with primary particles.

However, the lithium transition metal oxide in the form of secondary particles easily causes particle cracking during the electrode rolling process, which increases the specific surface area of the active material, so that the deterioration of storage and life performance at high temperatures is intensified. Such particle cracking of such secondary particles is more pronounced in small particles having an average particle diameter (D50) of about 5 μm.

KR 10-2019-0127725 describes a positive electrode active material for a lithium secondary battery containing an active material powder including secondary particles that are aggregates of primary particles into and from which lithium ions are doped and dedoped, wherein the secondary particles have voids therein.

KR 10-2014-0098350 and KR 2019 0041715 A relate to a positive electrode in which a positive electrode mixture including a positive electrode active material, a conductive material and a binder is coated on a current collector, wherein the positive electrode active material is a bimodal form of lithium composite oxide composed of small particles and large particles having the same chemical composition and different average particle diameters.

Therefore, there is a high need to develop a positive electrode capable of minimizing particle cracking during rolling of a positive electrode including the lithium transition metal oxide as an active material, thus improving life characteristics at high temperatures.

# [DETAILED DESCRIPTION OF THE INVENTION]

## [Technical Problem]

The present disclosure is intended to optimize the composition, mixing conditions, and rolling conditions of the positive electrode active material to minimize particle cracking of the positive electrode active material, thereby improving the life characteristics of a secondary battery including the same at high temperatures.

## [Technical Solution]

Terms or words used in the present specification and claims should not be construed as limited to ordinary or dictionary terms, and the present disclosure should be construed with meanings and concepts that are consistent with the technical idea of the present disclosure based on the principle that the inventors may appropriately define concepts of the terms to appropriately describe their own disclosure in the best way.

A positive electrode active material, a preparation method thereof, and a secondary battery including the same according to one embodiment of the present disclosure will now be described.

According to one embodiment of the present disclosure, there is provided a positive electrode in which a positive electrode mixture containing a positive electrode active material is formed on a positive electrode current collector,

wherein the positive electrode active material includes a lithium transition metal oxide powder represented by the following chemical formula 1,

$$Li_aNi_xCo_yM_zO_{2-w}A_w \qquad (1)$$

wherein,

M is at least one selected from the group consisting of Mn, Ti, Mg, Al, and Zr,

A is an oxygen-substituted halogen, and

$1.00 \leq a \leq 1.05$, $0.1 \leq x \leq 0.8$, $0.1 \leq y \leq 0.8$, $0.01 \leq z \leq 0.4$, and $0 \leq w \leq 0.001$,

wherein the lithium transition metal oxide powder is composed of:

large particles in which secondary particles are formed by aggregating primary particles, and an average particle diameter (D50) of the secondary particles is 7 $\mu$m to 17 $\mu$m, and

small particles in which single particles are formed and having an average particle diameter (D50) of 2 $\mu$m to 7 $\mu$m, wherein a mixing ratio of the large particles and the small particles is 5:5 to 9:1 based on the weight, and

wherein the positive electrode mixture has a porosity of 22% to 35%.

Specifically, the average particle size (D50) of the large particles may be 9 $\mu$m to 11 $\mu$m, and the average particle size (D50) of the small particles may be 4 $\mu$m to 6 $\mu$m.

Further, specifically, the mixing ratio of the large particles and the small particles may be 6:4 to 8:2 based on the weight,

Further, specifically, a porosity of the positive electrode mixture may be 24% to 30%.

Moreover, an electrode density of the positive electrode may be 3.0 g/cc to 3.6 g/cc, and specifically, an electrode density of the positive electrode may be 3.2 g/cc to 3.45 g/cc.

Meanwhile, in the lithium transition metal oxide powder of the chemical formula 1 contained in the positive electrode active material, the M is $Mn_bAl_c$, where $0 \leq b \leq 1$, and $0 \leq c \leq 1$.

The positive electrode mixture may further include a binder and a conductive material, wherein the binder is contained in an amount of 1 to 5% by weight based on the total weight of the positive electrode mixture, and the conductive material is contained in an amount of 0.5 to 5% by weight based on the total weight of the positive electrode mixture.

According to another embodiment of the present disclosure, there is provided a secondary battery having a structure in which an electrode assembly is built in a battery case in a state of being impregnated with an electrolyte, with the electrode assembly including: the positive electrode, a negative electrode and a separator interposed between the positive electrode and the negative electrode.

## [ADVANTAGEOUS EFFECTS]

The positive electrode according to the present disclosure includes a positive electrode active material obtained by forming single particles with small particles of lithium transition metal oxide powder, and the porosity of the positive electrode mixture according to the mixing ratio of large particles and small particles and rolling conditions is set in the optimum range, thereby improving the high temperature life characteristics of the secondary battery including the same.

**[DETAILED DESCRIPTION OF THE EMBODIMENTS]**

Hereinafter, a positive electrode and a secondary battery according to the present disclosure will be described in more detail.

According to one embodiment of the present disclosure, there is provided a positive electrode in which a positive electrode mixture containing a positive electrode active material is formed on a positive electrode current collector,

wherein the positive electrode active material includes a lithium transition metal oxide powder represented by the following chemical formula 1,

$$Li_aNi_xCo_yM_zO_{2-w}A_w \qquad (1)$$

wherein,

M is at least one selected from the group consisting of Mn, Ti, Mg, Al, and Zr,

A is an oxygen-substituted halogen, and

$1.00 \leq a \leq 1.05$, $0.1 \leq x \leq 0.8$, $0.1 \leq y \leq 0.8$, $0.01 \leq z \leq 0.4$, and $0 \leq w \leq 0.001$,

wherein the lithium transition metal oxide powder is composed of:

large particles in which secondary particles are formed by aggregating primary particles, and an average particle diameter (D50) of the secondary particles is 7 $\mu$m to 17 $\mu$m, and

small particles in which single particles are formed and having an average particle diameter (D50) of 2 $\mu$m to 7 $\mu$m,

wherein a mixing ratio of the large particles and the small particles is 5:5 to 9:1 based on the weight, and

wherein the positive electrode mixture has a porosity of 22% to 35%.

As described above, generally, the lithium transition metal oxide represented by the chemical formula 1 as a positive electrode active material is used in a secondary particle state.

Further, large particles having an average particle diameter (D50) of about 11 $\mu$m and small particles having an average particle diameter (D50) of about 5 $\mu$m are mixed and used, but there is a problem that in the electrode rolling process, the lithium transition metal oxide powder in the form of secondary particles is cracked.

In particular, the particle cracking occurred mostly in the small particles, and partial particle cracking occurred in the large particles.

Therefore, the present inventors have found that in order to solve the above-mentioned problems, when single particles are formed with small particles in the lithium transition metal oxide powder, the particle cracking can be reduced. However, when large particles in the form of secondary particles and small particles in the form of single particles are mixed, cracking of the large particles in the form of secondary particles is increased than a conventional case where the large particles in the form of secondary particles and the small particles are mixed, depending on the mixing conditions and rolling conditions of the large particles and the small particles, so that the deterioration in lifespan may become larger. Thus, the inventors have found out the optimal mixing ratio of large particles and small particles, the porosity according to rolling, and the optimized electrode density, in which the cracking of large particles in the form of secondary particles does not increase compared to the existing configuration, and completed the present disclosure.

Therefore, in the positive electrode according to the present disclosure, the lithium transition metal oxide powder of the chemical formula 1 included as a positive electrode active material was composed of a mixture of large particles in the form of secondary particles and small particles in the form of single particles.

In general, most of the lithium transition metal oxide in the form of single particles has an average particle diameter (D50) of about 5 $\mu$m, and it is easy to produce small particles in the form for single particles, but in order to produce large particles in the form of single particles, the heat treatment temperature and time are too high and thus, the preparation is not easy. As the particle size of the single particles increases, the charge/discharge efficiency and C-rate characteristics rapidly decrease. Thus, it is preferable to use large particles in the form of secondary particles.

In the present disclosure, the form of secondary particles means a state in which tens to hundreds of primary particles are aggregated, the form of single particles means a form in which primary particles are present individually or aggregated with less than 10 particles.

At this time, the diameter of the major axis of the primary particles constituting the large particles in the form of secondary particles may be, for example, 100 nm to 1000 nm, and the diameter of the major axis of the primary particles constituting the small particles in the form of single particles may be 500 nm to 7000 nm.

The average particle diameter (D50) of the large particles in the form of secondary particles formed by aggregation of tens to hundreds of such primary particles may be 7 $\mu$m to 17 $\mu$m, as defined above, and specifically, it may be 9 μm to 11 μm.

Further, the average particle diameter (D50)of the small particles in the form of single particles in which primary particles are present individually or aggregated with less than 10 particles may be 2 μm to 7 μm, as defined above, and specifically, it may be 4 μm to 6 μm.

When the average particle diameter (D50) of the large particles and the average particle diameter (D50) of the small particles are outside the above range, and the average particle diameter of the large particles is too large, the low efficiency and low C-rate characteristics of small particles in the form of single particles are weighted, thereby exhibiting a decrease in capacity and a decrease in output. When the average particle diameter of large particles is too small, electrode rollability is deteriorated, and particle cracking of large particles is intensified during rolling due to small particles in the form of single particles, which may cause deterioration in high temperature life. Meanwhile, when the average particle size of small particles in the form of single particles is too small, the preparation is difficult due to the deterioration in processability, and when the average particle size is too large, charging/discharging efficiency and C-rate characteristics are deteriorated, which is not preferable.

Here, the average particle diameter (D50) means the diameter at a point where the cumulative distribution of the volume of particles according to the particle size is 50%. The average particle diameter (D50) can be measured using a laser diffraction method. Specifically, after the powder to be measured is dispersed in a dispersion medium, it is introduced into a commercially available laser diffraction particle size measuring device (for example, Microtrac S3500) to measure the difference in the diffraction pattern according to the particle size when the particles pass through a laser beam, thereby calculating the particle size distribution. D50 can be measured by calculating the particle diameters at points where the cumulative distribution of the volume of particles according to the particle size in the measuring device is 50%.

Meanwhile, according to the present disclosure, when small particles in the form of single particles and large particles in the form of secondary particles are mixed as described above, particle cracking of large particles in the form of secondary particles may rather increase depending on the mixing conditions and the conditions of porosity and electrode density according to rolling. Therefore, it is very important to adjust the mixing ratio of large particles and small particles and the porosity according to rolling.

Firstly, the mixing of the large particle and the small particle may be performed by preparing each of these particles separately. At this time, the mixing ratio for exhibiting the effect of the present disclosure may be specifically 5:5 to 9:1, more specifically, 6:4 to 8:2, and still more specifically 7:3.

When the content of the small particles is too high outside the above range, the particle cracking of the large particles during electrode rolling are intensified by the small particles with stronger particle strength, and the high temperature life may be deteriorated. When the content of the small particles is too low, the filling rate due to the small particles is small and the electrode density decreases, which is not preferable.

Secondly, in order to exhibit the effect of the present disclosure, the porosity of the positive electrode mixture according to the adjustment of the rolling conditions may be 22% to 35%, specifically, 24% to 30%, and more specifically, 25% to 28%.

Here, the porosity is calculated as follows by using the ratio of the electrode density to the true density of the total solid content of the positive electrode mixture.

$$\text{(True density - Electrode density) / True density X 100}$$

When the porosity is too small outside the above range, this means that the rolling strength is high. Therefore, there is a problem in that the particle cracking of the large particles in the form of secondary particles is increased. When the porosity is too large, the rolling strength is low, but the electrode density decreases accordingly, which is not preferable in terms of energy density. There is a problem that the output is lowered due to the loss of the conductive path between particles.

Based on the optimization of the porosity according to the mixing ratio of the large particle and the small particle and the rolling conditions, the electrode density in the most preferable range for exerting the effects of the present disclosure can be determined, and the electrode density in the preferred range of the positive electrode according to the present disclosure may be 3.0 g/cc to 3.6 g/cc, and specifically 3.3 g/cc to 3.45 g/cc.

The electrode density may be calculated as the weight per unit volume excluding the electrode current collector.

When the electrode density is too small outside the above range, energy per volume is lowered, which is not preferable. When the electrode density is too large, there is a problem that particle cracks of the secondary particles increases and the high temperature life characteristic is rather deteriorated.

Meanwhile, the positive electrode active material may include a lithium transition metal oxide powder represented by the chemical formula 1. Specifically, in the chemical formula 1, M may be $Mn_bAl_c$, where $0 \leq b \leq 1$ and $0 \leq c \leq 1$. In other words, the lithium transition metal oxide powder included as the positive electrode active material has, specifically, a transition metal in its composition, and may include one or more selected from the group consisting of Li-Ni-Co-Mn oxide containing Ni, Co, and Mn, Li-Ni-Co-Al oxide containing Ni, Co, and Al, and Li-Ni-Co-Mn-Al oxide containing Ni, Co, Mn, and Al.

Including the lithium transition metal oxide powder represented by the chemical formula 1 may mean independently including a lithium transition metal oxide having one composition selected from the range of the chemical formula 1, but when it is within the range of the chemical formula 1, it may be in the form of a mixture of lithium transition metal oxide powders having several compositions.

Furthermore, the positive electrode active material may further include compounds known as conventional positive electrode active materials such as $LiNiO_2$, $LiMnO_2$, $LiMn_2O_4$, $LiCO_{1-d}Mn_dO_2$, $LiNi_{1-d}Mn_dO_2(0.2<d<1)$, $Li(Ni_a\text{-}Co_bMn_c)O_4$ $(0<a<2, 0<b<2, 0<c<2, a+b+c=2)$, $LiMn_{2-e}Ni_eO_4$, $LiMn_{2-e}Co_eO_4$ $(0<e<2)$, $LiCoPO_4$, or $LiFePO_4$, in addition to the lithium transition metal oxide represented by the chemical formula 1, and it goes without saying that one alone or a mixture of two or more of them may be further included in a small amount.

However, the lithium transition metal oxide represented by the chemical formula 1 may be included in an amount of at least 60% by weight or more based on the total weight of the positive electrode active material.

The positive electrode mixture may, in addition to the positive electrode active material, further include a binder and a conductive material, and optionally, may further include a filler.

The conductive material is used to impart conductivity to the electrode, and in the battery to be configured, the conductive material can be used without particular limitation as long as it does not cause chemical changes and has electronic conductivity. Specific examples include carbon-based materials such as carbon black, acetylene black, ketjen black, channel black, furnace black, lamp black, thermal black and carbon fiber, single-walled carbon nanotubes (SWCNT), multi-walled carbon nanotubes (MWCNT); graphite such as natural graphite and artificial graphite; metal powder or metal fibers such as copper, nickel, aluminum and silver; conductive whiskey such as zinc oxide and potassium titanate; conductive metal oxides such as titanium oxide; or a conductive polymer such as a polyphenylene derivative. Any one alone or a mixture of two or more of them may be used. The conductive material may be included in an amount of 0.1% to 30% by weight, specifically 0.3% to 10% by weight, and more specifically 0.5% to 5% by weight, based on the total weight of the positive electrode mixture.

The binder plays a role of improving adhesion between the positive electrode active material particles and adhesive strength between the positive electrode active material and the current collector. Specific examples include polyvinylidene fluoride (PVDF), vinylidene fluoride-hexafluoropropylene copolymer (PVDF-co-HFP), polyvinyl alcohol, polyacrylonitrile, carboxymethylcellulose (CMC), starch, hydroxypropylcellulose, regenerated cellulose, polyvinylpyrrolidone, polytetrafluoroethylene, polyethylene, polypropylene, ethylene-propylene-diene polymer (EPDM), sulfonated-EPDM, styrene butadiene rubber (SBR), fluororubber, or various copolymers thereof, and any one alone or a mixture of two or more of them may be used. The binder may be included in an amount of 1% to 30% by weight, specifically 1% to 10% by weight and more specifically 1% to 5% by weight, based on the total weight of the positive electrode mixture.

Further, the filler is optionally used as a component for inhibiting the expansion of positive electrode. The filler is not particularly limited so long as it is a fibrous material that does not cause chemical changes in the corresponding secondary battery. Examples of the filler include olefin-based polymers such as polyethylene and polypropylene; and fibrous materials such as glass fiber and carbon fiber. In this case, the filler may be added in an amount of 0.1 to 3% by weight based on the total weight of the positive electrode mixture.

The positive electrode current collector is not particularly limited as long as it has conductivity while not causing chemical changes to the battery, and for example, stainless steel, aluminum, nickel, titanium, calcined carbon, or aluminum or stainless steel having a surface treated with carbon, nickel, titanium, silver, etc. may be used. In addition, the positive electrode current collector may have a thickness of 3 $\mu$m to 500 $\mu$m, and may have fine irregularities formed on the surface of the current collector to increase the adhesion of the positive electrode active material. For example, it may be used in various forms such as films, sheets, foils, nets, porous bodies, foams, and nonwoven fabrics.

Further, according to another embodiment of the present disclosure, there is provided a secondary battery having a structure in which an electrode assembly is built in a battery case in a state of being impregnated with an electrolyte solution, with the electrode assembly including:

the positive electrode,
a negative electrode, and
a separator interposed between the positive electrode and the negative electrode.

Specifically, the secondary battery may be a lithium secondary battery.

The negative electrode may also be manufactured in a form in which a negative electrode mixture including a negative electrode active material is applied on a negative electrode current collector, and the negative electrode mixture may further include a conductive material and a binder as described above, together with the negative electrode active material and optically, a filler.

As the negative electrode active material, a compound capable of reversibly intercalating and deintercalating lithium may be used. Specific examples thereof may include carbonaceous materials such as artificial graphite, natural graphite, graphitized carbon fibers and amorphous carbon; metallic substances capable of alloying with lithium, such as Si, Al, Sn, Pb, Zn, Bi, In, Mg, Ga, Cd, Si alloy, Sn alloy or Al alloy; metal oxides capable of doping and undoping lithium, such as $SiO_x$ (0<x<2), $SnO_2$, vanadium oxide and lithium vanadium oxide; or a composite including the above metallic substance and the carbonaceous material such as a Si-C composite or a Sn-C composite, or the like, and any one or a mixture of two or more of them may be used. **In** addition, a metal lithium thin film may be used as the anode active material. Further, both low crystalline carbon and high crystalline carbon may be used as the carbon material. Typical examples of the low crystalline carbon may be soft carbon and hard carbon. Typical examples of the high crystalline carbon may be amorphous, planar, flaky, spherical or fibrous natural or artificial graphite, Kish graphite, pyrolytic carbon, mesophase pitch based carbon fiber, meso-carbon microbeads, mesophase pitches, and high-temperature calcined carbon such as petroleum or coal tar pitch derived cokes.

The negative electrode current collector is not particularly limited as long as it has high conductivity without causing chemical changes to the battery. For example, copper, stainless steel, aluminum, nickel, titanium, calcined carbon, copper or stainless steel having a surface treated with carbon, nickel, titanium, silver, etc., aluminum-cadmium alloy, and the like may be used. In addition, the anode current collector may generally have a thickness of 3μm to 500μm, and, like the cathode current collector, may have fine irregularities formed on the surface thereof to enhance the bonding strength of the anode active material. For example, it may be used in various forms such as films, sheets, foils, nets, porous bodies, foams and nonwoven fabrics.

The separator separates the negative electrode and the positive electrode, and provides a passage for lithium ions to migrate. Any separator may be used without particular limitation as long as it is generally used as a separator in a lithium secondary battery. In particular, a separator having excellent moisture-retention ability for an electrolyte while having low resistance to the migration of electrolyte ions is preferable. Specifically, a porous polymer film, for example, a porous polymer film made of polyolefin-based polymers such as ethylene homopolymer, propylene homopolymer, ethylene/butene copolymer, ethylene/hexene copolymer, and ethylene/methacrylate copolymer, or a laminated structure having two or more layers thereof may be used. In addition, a conventional porous nonwoven fabric, for example, a nonwoven fabric made of high melting point glass fiber, polyethylene terephthalate fiber, or the like may also be used. In addition, in order to secure heat resistance or mechanical strength, a coated separator containing a ceramic component or a polymer material may be used, and optionally, a single layer or a multilayer structure may be used.

In addition, the electrolyte used in the present disclosure may include, but is not limited to, an organic liquid electrolyte, an inorganic liquid electrolyte, a solid polymer electrolyte, a gel polymer electrolyte, a solid inorganic electrolyte, a molten inorganic electrolyte or the like which can be used in the preparation of a lithium secondary battery.

Specifically, the electrolyte may include an organic solvent and a lithium salt.

As the organic solvent, any solvent may be used without particular limitation as long as it can serve as a medium through which ions involved in the electrochemical reaction of the battery can migrate. Specifically, as the organic solvent, an ester-based solvent such as methyl acetate, ethyl acetate, γ-butyrolactone, or ε-caprolactone; an ether-based solvent such as dibutyl ether or tetrahydrofuran; a ketone-based solvent such as cyclohexanone; an aromatic hydrocarbon-based solvent such as benzene or fluorobenzene; a carbonate-based solvent such as dimethyl carbonate (DMC), diethylcarbonate (DEC), methylethylcarbonate (MEC), ethylmethylcarbonate (EMC), ethylene carbonate (EC), or propylene carbonate (PC) ; an alcohol-based solvent such as ethyl alcohol or isopropyl alcohol; nitriles such as R-CN (where R is a straight, branched or cyclic C2-C20 hydrocarbon group, and may include a double-bond aromatic ring or ether bond); amides such as dimethylformamide; dioxolanes such as 1,3-dioxolane; or sulfolanes may be used. Among them, the carbonate-based solvent is preferable, and a mixture of a cyclic carbonate (e.g., ethylene carbonate, propylene carbonate, etc.) having high ionic conductivity and a high-dielectric constant, which may increase charge/discharge performance of the battery, and a low-viscosity linear carbonate-based compound (e.g., ethyl methyl carbonate, dimethyl carbonate, diethyl carbonate, etc.) may be more preferably used. In this case, when the cyclic carbonate and the chain carbonate are mixed and used in a volume ratio of about 1:1 to about 1:9, the electrolyte may exhibit excellent performance.

The lithium salt may be used without particular limitation as long as it is a compound capable of providing lithium ions used in a lithium secondary battery. Specifically, $LiPF_6$, $LiClO_4$, $LiAsF_6$, $LiBF_4$, $LiSbF_6$, $LiAlO_4$, $LiAlCl_4$, $LiCF_3SO_3$, $LiC_4F_9SO_3$, $LiN(C_2F_5SO_3)_2$, $LiN(C_2F_5SO_2)_2$, $LiN(CF_3SO_2)_2$. LiCl, LiI, or $LiB(C_2O_4)_2$, or the like may be used as the lithium salt. It is preferable to use the lithium salt in a concentration rage of 0.1 M to 2.0 M. If the concentration of the lithium salt is within the above range, since the electrolyte has an appropriate conductivity and viscosity, excellent electrolyte performance can be exhibited, and lithium ions can effectively migrate.

In order to improve the lifespan characteristics of the battery, suppress a reduction in battery capacity and improve discharge capacity of the battery, for example, one or more additives such as a halo-alkylene carbonate-based compound such as difluoroethylene carbonate, pyridine, triethylphosphite, triethanolamine, cyclic ether, ethylene diamine, n-glyme, hexaphosphoric triamide, a nitrobenzene derivative, sulfur, a quinone imine dye, N-substituted oxazolidinones, N,N-substituted imidazolidine, ethylene glycol dialkyl ether, an ammonium salt, pyrrole, 2-methoxy ethanol, or aluminum trichloride may be further added to the electrolyte solution in addition to the above electrolyte components. In this case, the additive may be included in an amount of 0.1% to 5% by weight based on the total weight of the electrolyte solution.

The secondary battery according to the present disclosure as described above may be used as a power source of devices in portable devices such as mobile phones, notebook computers, digital cameras, and electric vehicles such as hybrid electric vehicles (HEVs).

Hereinafter, embodiments of the present disclosure will be described in detail so that those skilled in the art can easily implement them. The present disclosure may be modified in various different ways, and is not limited to the embodiments forth herein.

<Preparation Example 1> (Large Particles in the Form of Secondary Particles)

In a 5L batch reactor set at 60°C, nickel sulfate, cobalt sulfate and manganese sulfate were mixed in a molar ratio of 70:10:20 in water to prepare a metal salt solution of 2M concentration. The container containing the metal salt is connected so as to enter the reactor. A 4M NaOH solution and a 7% aqueous $NH_4OH$ solution were prepared and connected to each reactor. 3 liters of deionized water was added to a co-precipitation reactor (capacity of 5L), nitrogen gas was purged into the reactor at a rate of 2 liters/minute to remove dissolved oxygen in the water, and the inside of the reactor was made into a non-oxidizing atmosphere. Then, 100ml of 4M NaOH was added, and then maintained so as to reach pH 12.0 at a stirring speed of 1200rpm at a temperature of 60°C. Then, the metal salt solution was added at a rate of 180 ml/hr, an aqueous NaOH solution at a rate of 180 ml/hr, and an aqueous $NH_4OH$ solution at a rate of 10 ml/hr, and subjected to a coprecipitation reaction for 10 hours to synthesize a nickel cobalt manganese composite oxyhydroxide of $Ni_{0.7}Co_{0.1}Mn_{0.2}(OH)_2$ (average particle diameter (D50): 11 $\mu$m).

The particles of the resulting nickel cobalt manganese-based composite metal hydroxide were mixed with lithium hydroxide as a lithium raw material at a molar ratio of 1:1.07, and then heat-treated at 860°C for 15 hours in air to obtain large particles $LiNi_{0.7}Co_{0.1}Mn_{0.2}O_2$ powder (average particle diameter (D50): 11 $\mu$m).

In the SEM observation, the large particle positive electrode powder was the form of secondary particles obtained by aggregating several tens or more of primary particles, and the shape thereof was spherical or elliptical.

<Preparation Example 2> (Small Particles in the Form of Single Particles)

A nickel cobalt manganese composite oxyhydroxide of $Ni_{0.7}Co_{0.1}Mn_{0.2}(OH)_2$ (average particle size (D50): 4.5 $\mu$m) was synthesized in the same manner as in Preparation Example 1, except that the coprecipitation reaction time was reduced to 3 hours in Preparation Example 1.

The particles of the resulting nickel cobalt manganese-based composite metal hydroxide were mixed with lithium hydroxide as a lithium raw material at a molar ratio of 1:1, and then heat-treated at 950°C for 15 hours in air to obtain small particle $LiNi_{0.7}Co_{0.1}Mn_{0.2}O_2$ powder (average particle diameter (D50): 5 $\mu$m).

In the SEM observation, the small particle positive electrode powder was a form in which primary particles are present individually or aggregated with less than 10 particles, and the shape thereof was spherical or elliptical.

<Preparation Example 3> (Small Particles in the Form of Secondary Particles)

A nickel cobalt manganese composite oxyhydroxide of $Ni_{0.7}Co_{0.1}Mn_{0.2}(OH)_2$ (average particle size (D50): 4.5 $\mu$m) was synthesized in the same manner as in Preparation Example 1, except that the coprecipitation reaction time was reduced to 3 hours in Preparation Example 1.

The particles of the resulting nickel cobalt manganese-based composite metal hydroxide were mixed with lithium hydroxide as a lithium raw material at a molar ratio of 1:1.7, and then heat-treated at 840°C for 15 hours in air to obtain small particle $LiNi_{0.7}Co_{0.1}Mn_{0.2}O_2$ powder (average particle diameter (D50): 4.5 $\mu$m).

In the SEM observation, the small particle positive electrode powder was a form in which secondary particles were formed by aggregation of tens or more of such primary particles, and the shape thereof was spherical or elliptical.

<Example 1>

The large particle positive electrode powder prepared in Preparation Example 1 and the small particle positive electrode powder prepared in Preparation Example 2 were mixed in a weight ratio of 7:3, and used as a positive electrode active material. PVdF was used as a binder and carbon black was used as a conductive material. Positive electrode active material: binder: conductive material were mixed well in a weight ratio of 96: 2: 2 with NMP to produce a slurry (viscosity: 5000 mPa s), which was then applied to a 20 $\mu$m-thick Al current collector, dried at 130° C, and then rolled at a pressure of 1.7 ton/cm to produce a 74.5 um -thick positive electrode.

<Example 2>

A positive electrode was prepared in the same manner as in Example 1, except that in Example 1, the large particle positive electrode powder prepared in Preparation Example 1 and the small particle positive electrode powder prepared in Preparation Example 2 were mixed in a weight ratio of 5:5, and used as a positive electrode active material.

<Example 3>

A positive electrode was prepared in the same manner as in Example 1, except that in Example 1, the large particle positive electrode powder prepared in Preparation Example 1 and the small particle positive electrode powder prepared in Preparation Example 2 were mixed in a weight ratio of 8:2, and used as a positive electrode active material.

<Example 4>

A positive electrode was prepared in the same manner as in Example 1, except that in Example 1, the rolling pressure was 2.1 ton/cm, and the electrode thickness was 73.1 um.

<Example 5>

A positive electrode was prepared in the same manner as in Example 1, except that in Example 1, the rolling pressure was 1.1 ton/cm, and the electrode thickness was 76.8 um.

<Example 6>

A positive electrode was prepared in the same manner as in Example 1, except that in Example 1, the rolling pressure was 0.7 ton/cm, and the electrode thickness was 78.4 um.

<Comparative Example 1>

A positive electrode was prepared in the same manner as in Example 1, except that the large particle positive electrode powder prepared in Preparation Example 1 and the small particle positive electrode powder prepared in Preparation Example 3 were mixed in a weight ratio of 7:3.

<Comparative Example 2>

A positive electrode was prepared in the same manner as in Example 1, except that in Example 1, the large particle positive electrode powder prepared in Preparation Example 1 and the small particle positive electrode powder prepared in Preparation Example 2 were mixed in a weight ratio of 4:6 and used as a positive electrode active material.

<Comparative Example 3>

A positive electrode was prepared in the same manner as in Example 1, except that in Example 1, the rolling pressure was 2.5 ton/cm, and the electrode thickness was 71.8 um.

<Comparative Example 4>

A positive electrode was prepared in the same manner as in Example 1, except that in Example 1, the rolling pressure was 0.2 ton/cm, and the electrode thickness was 82.8 um.

<Experimental Example 1>

In the positive electrodes prepared in Examples 1 to 6 and Comparative Examples 1 to 4, the porosity and electrode density of the positive electrode mixture were obtained as follows, and the results are shown in Table 1 below.

* The porosity was calculated as follows by using the ratio of the electrode density to the true density of the total solid content of the positive electrode mixture.

$$(\text{True density - Electrode density}) / \text{True density X 100}$$

*The electrode density was calculated as the weight per unit volume excluding the electrode current collector.

[Table 1]

|  | Porosity (%) | Electrode density (g/cc) |
|---|---|---|
| Example 1 | 25 | 3.36 |
| Example 2 | 25 | 3.36 |
| Example 3 | 25 | 3.36 |
| Example 4 | 23 | 3.45 |
| Example 5 | 28 | 3.21 |
| Example 6 | 30 | 3.15 |
| Comparative Example 1 | 25 | 3.36 |
| Comparative Example 2 | 25 | 3.36 |
| Comparative Example 3 | 21 | 3.55 |
| Comparative Example 4 | 36 | 2.86 |

<Experimental Example 2>

The positive electrodes prepared in Examples 1 to 6 and Comparative Examples 1 to 4, and lithium metal as the negative electrode were used, and an electrolyte solution containing 1M $LiPF_6$ in a solvent of EC: DMC: DEC = 1: 2: 1 was used to prepare a half coin cell.

The prepared half coin cell was charged at 25°C with a constant current (CC) of 0.1 C until it becomes 4.25 V, and then charged with a constant voltage (CV) of 4.25V, and the first charging was performed until the charging current became 0.05mAh. Thereafter, it was left for 20 minutes and then discharged at a constant current of 0.1C until it became 3.0V, and the discharge capacity at the first cycle was measured.

It was charged at 0.5C to 4.25V under constant current/constant voltage (CC/CV) conditions at 45°C, and charged until it became 0.05mAh, and then discharged at 1C to 3.0 V under constant current (CC) conditions, and this was set as 1 cycle, and this was repeated up to 50 cycles. The value calculated by (capacity after 50 cycles/capacity after 1 cycle) x 100 was defined as the high-temperature life retention rate (%), and the results are shown in Table 2 below.

[Table 2]

|  | Capacity retention rate (%) at 45°C |
|---|---|
| Example 1 | 93 |
| Example 2 | 89 |
| Example 3 | 92 |
| Example 4 | 89 |
| Example 5 | 94 |
| Example 6 | 92 |
| Comparative Example 1 | 88 |
| Comparative Example 2 | 86 |
| Comparative Example 3 | 85 |
| Comparative Example 4 | 85 |

Referring to Table 2 together with Table 1, it can be confirmed that when a positive electrode satisfying the conditions of the present disclosure is used, particle cracking is small and thus high temperature life characteristics are excellent.

**Claims**

1. A positive electrode in which a positive electrode mixture containing a positive electrode active material is formed on a positive electrode current collector,

    wherein the positive electrode active material includes a lithium transition metal oxide powder represented by the following chemical formula 1,

    $$Li_aNi_xCo_yM_zO_{2-w}A_w \qquad (1)$$

    wherein,
    M is at least one selected from the group consisting of Mn, Ti, Mg, Al, and Zr,
    A is an oxygen-substituted halogen, and
    $1.00 \le a \le 1.05$, $0.1 \le x \le 0.8$, $0.1 \le y \le 0.8$, $0.01 \le z \le 0.4$, and $0 \le w \le 0.001$,
    wherein the lithium transition metal oxide powder is composed of:

        large particles in which secondary particles are formed by aggregating primary particles, and an average particle diameter (D50) of the secondary particles is 7 $\mu$m to 17 $\mu$m, and
        small particles in which single particles are formed and having an average particle diameter (D50) of 2 $\mu$m to 7 $\mu$m, wherein single particles means a form in which primary particles are present individually or aggregated with less than 10 particles,
        wherein a mixing ratio of the large particles and the small particles is 5:5 to 9:1 based on the weight, and
        wherein the positive electrode mixture has a porosity of 22% to 35%.

2. The positive electrode according to claim 1, wherein the average particle size (D50) of the large particles is 9 $\mu$m to 11 $\mu$m.

3. The positive electrode according to claim 1, wherein the average particle size (D50) of the small particles is 4 $\mu$m to 6 $\mu$m.

4. The positive electrode according to claim 1, wherein the mixing ratio of the large particles and the small particles is 6:4 to 8:2 based on the weight,

5. The positive electrode according to claim 1, wherein a porosity of the positive electrode mixture is 24% to 30%.

6. The positive electrode according to claim 1, wherein an electrode density of the positive electrode is 3.0 g/cc to 3.6 g/cc.

7. The positive electrode according to claim 6, wherein an electrode density of the positive electrode is 3.2 g/cc to 3.45 g/cc.

8. The positive electrode according to claim 1, wherein the M is $Mn_bAl_c$, where $0 \le b \le 1$, and $0 \le c \le 1$.

9. The positive electrode according to claim 1, wherein the positive electrode mixture further comprises a binder and a conductive material.

10. The positive electrode according to claim 9, wherein the binder is contained in an amount of 1 to 5% by weight based on the total weight of the positive electrode mixture, and the conductive material is contained in an amount of 0.5 to 5% by weight based on the total weight of the positive electrode mixture.

11. A secondary battery having a structure in which an electrode assembly is built in a battery case in a state of being impregnated with an electrolyte solution, with the electrode assembly comprising:

    the positive electrode of claim 1,

a negative electrode, and
a separator interposed between the positive electrode and the negative electrode.

**Patentansprüche**

1. Positive Elektrode, in der ein Gemisch für eine positive Elektrode, die ein Aktivmaterial für eine positive Elektrode enthält, auf einem Stromabnehmer für einer positiven Elektrode ausgebildet ist,

   worin das Aktivmaterial für eine positive Elektrode ein durch die folgende chemische Formel I dargestelltes Lithium-Übergangsmetalloxidpulver enthält,

$$Li_aNi_xCo_yM_zO_{2-w}A_w \qquad (1)$$

   worin
   M mindestens eines ist, ausgewählt aus der Gruppe, bestehend aus Mn, Ti, Mg, Al und Zr,
   A ein Sauerstoff-substituiertes Halogen ist und $1,00 \leq a \leq 1,05$, $0,1 \leq x \leq 0,8$, $0,1 \leq y \leq 0,8$, $0,01 \leq z \leq 0,4$ und $0 \leq w \leq 0,001$, worin das Lithium-Übergangsmetalloxidpulver zusammengesetzt ist aus:

   großen Teilchen, in denen sekundäre Teilchen durch Aggregation primärer Teilchen ausgebildet sind, und ein durchschnittlicher Teilchendurchmesser (D50) der sekundären Teilchen 7 μm bis 17 μm beträgt, und kleinen Teilchen, in denen Einzelteilchen ausgebildet sind und die einen durchschnittlichen Teilchendurchmesser (D50) von 2 μm bis 7 μm aufweisen, worin Einzelteilchen eine Form bezeichnen, in der primäre Teilchen einzeln oder in Aggregaten mit weniger als 10 Teilchen vorliegen,
   worin ein Mischungsverhältnis der großen Teilchen und der kleinen Teilchen, basierend auf dem Gewicht, 5:5 bis 9:1 beträgt, und
   worin das Gemisch für eine positive Elektrode eine Porosität von 22% bis 35% aufweist.

2. Positive Elektrode gemäß Anspruch 1, worin die durchschnittliche Teilchengröße (D50) der großen Teilchen 9 μm bis 11 μm beträgt.

3. Positive Elektrode gemäß Anspruch 1, worin die durchschnittliche Teilchengröße (D50) der kleinen Teilchen 4 μm bis 6 μm beträgt.

4. Positive Elektrode gemäß Anspruch 1, worin das Mischungsverhältnis der großen Teilchen und der kleinen Teilchen, basierend auf dem Gewicht, 6:4 bis 8:2 beträgt.

5. Positive Elektrode gemäß Anspruch 1, worin eine Porosität des Gemischs für eine positive Elektrode 24% bis 30% beträgt.

6. Positive Elektrode gemäß Anspruch 1, worin eine Elektrodendichte der positiven Elektrode 3,0 g/cm$^3$ bis 3,6 g/cm$^3$ beträgt.

7. Positive Elektrode gemäß Anspruch 6, worin eine Elektrodendichte der positiven Elektrode 3,2 g/cm$^3$ bis 3,45 g/cm$^3$ beträgt.

8. Positive Elektrode gemäß Anspruch 1, worin das M $Mn_bAl_c$ ist, wobei $0 \leq b \leq 1$ und $0 \leq c \leq 1$.

9. Positive Elektrode gemäß Anspruch 1, worin das Gemisch für eine positive Elektrode ferner ein Bindemittel und ein leitfähiges Material umfasst.

10. Positive Elektrode gemäß Anspruch 9, worin das Bindemittel in einer Menge von 1 bis 5 Gew.-%, basierend auf dem Gesamtgewicht des Gemischs für eine positive Elektrode, enthalten ist, und das leitfähige Material in einer Menge von 0,5 bis 5 Gew.-%, basierend auf dem Gesamtgewicht des Gemischs für eine positive Elektrode, enthalten ist.

11. Sekundärbatterie, die eine Struktur aufweist, in der eine Elektrodenanordnung in einem Batteriegehäuse im Zustand der Imprägnierung mit einer Elektrolytlösung eingebaut ist, die Elektrodenanordnung umfassend:

die positive Elektrode gemäß Anspruch 1,
eine negative Elektrode und
einen zwischen der positiven und der negativen Elektrode angeordneten Separator.

**Revendications**

1. Électrode positive dans laquelle un mélange d'électrode positive contenant un matériau actif d'électrode positive est formé sur un collecteur de courant d'électrode positive,

   dans laquelle le matériau actif d'électrode positive inclut une poudre d'oxyde de métal de transition au lithium représentée par la Formule chimique 1 suivante :

   $$Li_aNi_xCo_yM_zO_{2-w}A_w \qquad (1),$$

   dans laquelle
   M est au moins un, sélectionné, faisant partie du groupe consistant en Mn, Ti, Mg, Al, et Zr,
   A est un halogène substitué par de l'oxygène, et
   $1,00 \leq a \leq 1,05$, $0,1 \leq x \leq 0,8$, $0,1 \leq y \leq 0,8$, $0,01 \leq z \leq 0,4$, et $0 \leq w \leq 0,001$,
   dans laquelle la poudre d'oxyde de métal de transition au lithium est composée de :

   des particules de grande taille dans lesquelles des particules secondaires sont formées en agrégeant des particules primaires, et un diamètre moyen de particules (D50) des particules secondaires est de 7 μm à 17 μm, et
   des particules de petite taille dans lesquelles des particules individuelles sont formées et présentant un diamètre moyen de particules (D50) de 2 μm à 7 μm, dans lesquelles « particules individuelles » signifie une forme dans laquelle des particules primaires sont présentes individuellement ou agrégées en un nombre inférieur à 10 particules,
   dans laquelle un rapport de mélange des particules de grande taille et des particules de petite taille est de 5:5 à 9:1 par rapport au poids, et
   dans laquelle le mélange d'électrode positive présente une porosité de 22 % à 35 %.

2. Électrode positive selon la revendication 1, dans laquelle la taille moyenne de particules (D50) des particules de grande taille est de 9 μm à 11 μm.

3. Électrode positive selon la revendication 1, dans laquelle la taille moyenne de particules (D50) des particules de petite taille est de 4 μm à 6 μm.

4. Électrode positive selon la revendication 1, dans laquelle le rapport de mélange des particules de grande taille et des particules de petite taille est de 6:4 à 8:2 par rapport au poids,

5. Électrode positive selon la revendication 1, dans laquelle une porosité du mélange d'électrode positive est de 24 % à 30 %.

6. Électrode positive selon la revendication 1, dans laquelle une densité d'électrode de l'électrode positive est de 3,0 g/cm³ à 3,6 g/cm³.

7. Électrode positive selon la revendication 6, dans laquelle une densité d'électrode de l'électrode positive est de 3,2 g/cm³ à 3,45 g/cm³.

8. Électrode positive selon la revendication 1, dans laquelle le M est $Mn_bAl_c$, avec $0 \leq b \leq 1$, et $0 \leq c \leq 1$.

9. Électrode positive selon la revendication 1, dans laquelle le mélange d'électrode positive comprend en outre un liant et un matériau conducteur.

10. Électrode positive selon la revendication 9, dans laquelle le liant est inclus en une quantité de 1 à 5 % en poids par rapport au poids total du mélange d'électrode positive, et le matériau conducteur est inclus en une quantité de 0,5 à 5 % en poids par rapport au poids total du mélange d'électrode positive.

11. Batterie rechargeable présentant une structure dans laquelle un ensemble d'électrodes est disposé dans un boîtier de batterie dans un état imprégné d'une solution électrolytique, l'ensemble d'électrodes comprenant :

l'électrode positive selon la revendication 1,
une électrode négative, et
un séparateur interposé entre l'électrode positive et l'électrode négative.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020190127725
- KR 1020140098350
- KR 20190041715 A